# EUROPEAN PATENT SPECIFICATION

(11) **EP 1 833 640 B1**
(45) Date of publication and mention of the grant of the patent: **09.09.2009**
(21) Application number: 05814728.1
(22) Date of filing: 06.12.2005
(51) Int. Cl.: B24B 37/00, B24B 37/04, H01L 21/304

(54) **SUBSTRATE HOLDING DEVICE AND POLISHING APPARATUS**
SUBSTRATHALTEEINRICHTUNG UND POLIERVORRICHTUNG
DISPOSITIF DE MAINTIEN D' UN SUBSTRAT ET APPAREIL DE POLISSAGE

(30) Priority: 10.12.2004 JP 2004358859
(43) Date of publication of application: 19.09.2007
(73) Proprietor: EBARA CORPORATION, Ohta-ku, Tokyo 144-8510 (JP)
(72) Inventor: Togawa, Tetsuji, Ebara Corporation, Tokyo, 1448510 (JP); Yoshida, Hiroshi, Ebara Corporation, Tokyo, 1448510 (JP); Nabeya, Osamu, Ebara Corporation, Tokyo, 1448510 (JP); Fukushima, Makoto, Ebara Corporation, Tokyo, 1448510 (JP); Fukaya, Koichi, Ebara Corporation, Tokyo, 1448510 (JP)
(74) Representative: Wagner, Karl H.
(86) International application number: PCT/JP2005/022735
(87) International publication number: WO 2006/062232

(56) References cited:
- EP-A- 1 066 924
- EP-A- 1 080 841
- WO-A-02/07931
- WO-A-20/04070806
- JP-A- 2001 038 604
- JP-A- 2004 297 029
- JP-A- 2004 516 644

## Description

### Technical Field

The present invention relates to a polishing apparatus for polishing a substrate, such as a semiconductor wafer, to form a flat and mirror-finished surface thereon, and more particularly to a substrate holding device for pressing a substrate via an elastic membrane against a polishing surface of the polishing apparatus.

### Background Art

In recent years, semiconductor devices have become small in size and structures of semiconductor elements have become more complicated. In addition, layers in multilayer interconnects used for a logical system have increased in number. Accordingly, irregularities on a surface of a semiconductor device are likely to increase and step heights are also likely to become large. This is because, during a manufacturing process of the semiconductor device, a thin film is formed on the semiconductor device, then micromachining processes, such as patterning or forming holes, are performed on the semiconductor device, and these processes are repeated many times to form subsequent thin films on the semiconductor device.

When irregularities on the surface of the semiconductor device increase, the following problems arise. When a thin film is formed on the semiconductor device, a thickness of the film formed on step portions is relatively small. Further, an open circuit may be caused by disconnection of interconnects, or a short circuit may be caused by insufficient insulation between interconnect layers. As a result, good products cannot be obtained, and a yield tends to be lowered. Even if a semiconductor device initially works normally, reliability of the semiconductor device is lowered after a long-term use. Further, at a time of exposure during a lithography process, if a irradiation surface has irregularities, then a lens unit in an exposure system is locally unfocused. Therefore, if the irregularities on the surface of the semiconductor device increase, then it becomes problematically difficult to form a fine pattern itself on the semiconductor device.

Thus, it becomes increasingly important in a manufacturing process of a semiconductor device to planarize the surface of the semiconductor device. One of the most important planarizing technologies is chemical mechanical polishing (CMP). The chemical mechanical polishing is performed using a polishing apparatus. Specifically, a substrate, such as a semiconductor wafer, is brought into sliding contact with a polishing surface while a polishing liquid containing abrasive particles such as silica (SiO₂) is supplied onto the polishing surface, so that the substrate is polished.

This kind of polishing apparatus comprises a polishing table having a polishing surface formed on a polishing pad, and a substrate holding device, which is called a top ring, for holding a semiconductor wafer. The polishing apparatus polishes a semiconductor wafer as follows. The substrate holding device holds the semiconductor wafer and presses the semiconductor wafer against the polishing surface at a certain pressure. In this state, the polishing table and the substrate holding device are moved relative to each other to bring the semiconductor wafer into sliding contact with the polishing surface, whereby the semiconductor wafer is polished to have a flat and mirror-finished surface.

In the above polishing apparatus, if a relative pressing force between the semiconductor wafer and the polishing surface of the polishing pad is not uniform over an entire surface of the semiconductor wafer during polishing, then the semiconductor wafer may be insufficiently polished or may be excessively polished at some portions depending on a pressing force applied to those portions of the semiconductor wafer. In order to avoid such a drawback, it has been attempted to form a substrate-holding surface of the substrate holding device with use of an elastic membrane made of elastic material such as rubber, and to apply fluid pressure such as air pressure to a backside surface of the elastic membrane so as to provide a uniform pressing force over the entire surface of the semiconductor wafer.

EP 10 80 841 A shows a polishing head comprising a head body having an upper mounting plate and a cylindrical circumference wall provided downward of the outer circumference of the upper mounting plate, a diaphragm provided in the head body, a disk-shaped carrier secured to the diaphragm, a first pressure adjustment mechanism for adjusting the pressure of a liquid filled in a fluid chamber formed between the carrier and the head body, and a retainer ring disposed in concentric relation between the lower face of the carrier and the inner wall of the circumference wall. The retainer ring is fixed to the carrier, and an elastic membrane is disposed on the lower face of the carrier. The elastic membrane is secured by inserting its circumference edge between the retainer ring and the carrier, a fluid feed passage for feeding a pressure variable fluid between the elastic membrane and the carrier is provided in the carrier.

Further, WO 2004 070 806 A1 relates to a substrate holding apparatus for holding a substrate such as a semiconductor wafer in a polishing apparatus for polishing the substrate to a flat finish. The substrate holding apparatus comprises a vertically movable member, and an elastic member for defining a chamber. The elastic member comprises a contact portion which is brought into contact with the substrate, and a circumferential wall extending upwardly from the contact portion and connected to the vertically movable member. The circumferential wall has a stretchable and contractible portion which is stretchable and contractible vertically.

However, use of such an elastic membrane may meet the following problems. When the semiconductor wafer is being rotated, the elastic membrane is twisted and deformed. As a result, a polishing rate, i.e., a removal rate, at a peripheral portion (edge portion) of the semiconductor wafer is greatly lowered compared with other portions. Further, due to such twist and deformation of the elastic membrane, a polishing profile may not be symmetrical, especially at the edge portion, about a center of the semiconductor wafer. Furthermore, individual difference of elastic membranes and retainer rings, which hold a peripheral portion of the semiconductor wafer, may cause a variation in polishing profiles among the top rings.

### Disclosure of Invention

The present invention has been made in view of the above drawbacks. It is, therefore, an object of the present invention to provide a substrate holding device and a polishing apparatus which can prevent twist and deformation of an elastic membrane attached to a substrate-holding surface to thereby achieve high-quality polishing.

In order to achieve the above objects, in accordance with the present invention, a substrate holding device as set forth in claim 1 and a polishing apparatus as set forth in claim 8 is provided. Further embodiments of the invention may be found in the dependent claims.

With these structures, when the elastic membrane is about to be twisted due to rotation of the substrate holding device, the projecting portions of the elastic membrane engages the engagement portions of the attachment member to thereby suppress twist of the elastic membrane to a minimal level. Therefore, a polishing profile can be appropriately controlled, and high-quality polishing can be achieved.

### Brief Description of Drawings

FIG. 1 is a schematic view showing a polishing apparatus according to a first embodiment of the present invention;
FIG. 2 is a vertical cross-sectional view showing a top ring of the polishing apparatus shown in FIG. 1;
FIG. 3 is a cross sectional view taken along line III-III shown in FIG. 2.

### Best Mode for Carrying Out the Invention

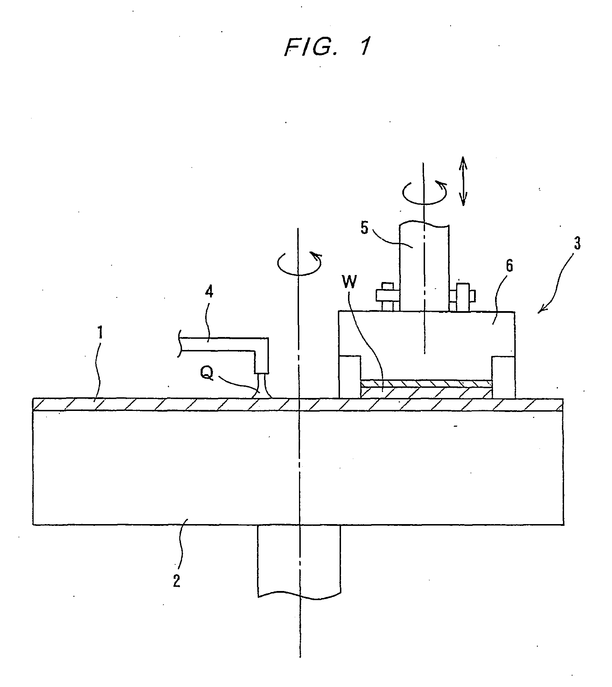

A polishing apparatus including a substrate holding device according to embodiments of the present invention will be described below in detail with reference to FIGS. 1 through 3. In FIGS. 1 through 3, identical or corresponding elements are denoted by the same reference numerals and will not be repetitively described.

FIG. 1 is a schematic view showing a polishing apparatus including a substrate holding device according to an embodiment of the present invention. As shown in FIG. 1, the polishing apparatus comprises a polishing table 2 having a polishing pad 1 attached to an upper surface of the polishing table 2, and a top ring 3 serving as a substrate holding device for holding a substrate such as a semiconductor wafer W and pressing it against the polishing pad 1 on the polishing table 2. A polishing liquid supply nozzle 4 is provided above the polishing table 2 so that a polishing liquid Q is supplied onto the polishing pad 1 through the polishing liquid supply nozzle 4. The top ring 3 comprises a top ring shaft 5, which is rotatable and vertically movable, and a top ring body 6 coupled to the top ring shaft 5. In this embodiment, an upper surface of the polishing pad 1 serves as a polishing surface.

When polishing the semiconductor wafer W, the polishing table 2 and the top ring 3 are independently rotated, and the top ring 3 presses the semiconductor wafer W against the polishing pad 1 on the polishing table 2 at a predetermined pressure, while the polishing liquid Q is being supplied onto the polishing pad 1 through the polishing liquid supply nozzle 4. During polishing, a surface, to be polished, of the semiconductor wafer W and the polishing pad 1 are in sliding contact with each other, whereby the surface of the semiconductor wafer W is polished to a flat and mirror finish.

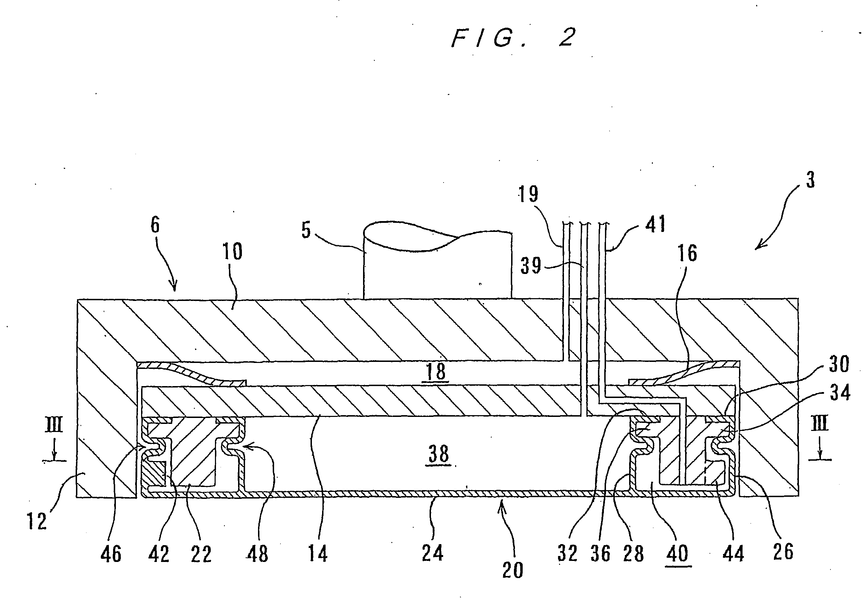

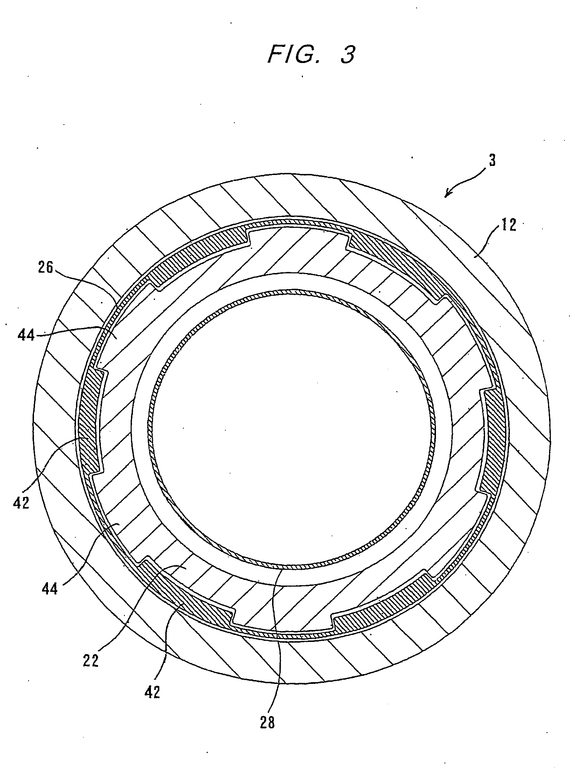

FIG. 2 is a vertical cross-sectional view showing details of the top ring 3 shown in FIG. 1, and FIG. 3 is a cross sectional view taken along line III-III shown in FIG. 2. As shown in FIG. 2, the top ring body 6 of the top ring 3 comprises a disk section 10 coupled to the top ring shaft 5, and a retainer ring section 12 configured to hold a peripheral portion of the semiconductor wafer. A vertically movable member 14 is housed in a space defined by the disk section 10 and the retainer ring section 12. The vertically movable member 14 is coupled to the top ring body 6 via an annular elastic sheet 16.

The top ring body 6, the vertically movable member 14, and the elastic sheet 16 define a pressure chamber 18 inside of these components. The pressure chamber 18 is connected to a fluid supply source (not shown) through a fluid passage 19. A regulator (not shown) is provided in the fluid passage 19 so that pressure of fluid to be supplied to the pressure chamber 18 can be adjusted by the regulator. This arrangement can control pressure in the pressure chamber 18, and can thus move the vertically movable member 14 in the vertical direction.

An elastic membrane 20 is attached to a lower surface of the vertically movable member 14 by an attachment member 22. The elastic membrane 20 is provided so as to cover the lower surface of the vertically movable member 14, and is configured to come into direct contact with a rear surface of the semiconductor wafer. In this specification, the rear surface of the semiconductor wafer means a surface opposite to a surface to be polished. The elastic membrane 20 is made of highly strong and durable rubber material such as ethylene propylene rubber (EPDM), polyurethane rubber, or silicone rubber.

As shown in FIG. 2, the elastic membrane 20 comprises a bottom-surface membrane 24 to be brought into contact with the rear surface of the semiconductor wafer, a first circumferential membrane 26 extending upwardly from a circumferential edge of the bottom-surface membrane 24, and a second circumferential membrane 28 positioned radially inwardly of the first circumferential membrane 26 and extending upwardly from the bottom-surface membrane 24. A radially inwardly extending portion 30 is formed on an upper edge portion of the circumferential membrane 26, and a radially outwardly extending portion 32 is formed on an upper edge portion of the circumferential membrane 28. The attachment member 22 has base portions 34 and 36 which press the extending portions 30 and 32 of the elastic membrane 20 against the vertically movable member 14 so as to secure the extending portions 30 and 32.

The bottom-surface membrane 24, the circumferential membrane 28, and the vertically movable member 14 define a pressure chamber 38 inside of these parts, and the pressure chamber 38 is connected to the fluid supply source through a fluid passage 39. A regulator (not shown) is also provided in the fluid passage 39 so that pressure of fluid to be supplied to the pressure chamber 38 can be adjusted by the regulator. With this arrangement, by adjusting pressure of fluid to be supplied the pressure chamber 38, pressure in the pressure chamber 38 can be controlled. Accordingly, a pressing force, which is applied from the bottom-surface membrane 24 to a portion of the semiconductor wafer underneath the pressure chamber 38, can be adjusted.

The bottom-surface membrane 24, the circumferential membrane 28, the circumferential membrane 26, and the vertically movable member 14 define a pressure chamber 40 inside of these parts, and the pressure chamber 40 is connected to the fluid supply source through a fluid passage 41. A regulator (not shown) is provided in the fluid passage 41 so that pressure of fluid to be supplied to the pressure chamber 40 can be adjusted by the regulator. With this arrangement, by adjusting pressure of fluid to be supplied the pressure chamber 40, pressure in the pressure chamber 40 can be controlled. Accordingly, a pressing force, which is applied from the bottom-surface membrane 24 to a portion of the semiconductor wafer underneath the pressure chamber 40, can be adjusted.

According to this embodiment, the pressures in the pressure chamber 38 and the pressure chamber 40 are independently controlled, so that a pressing force applied to a portion of the semiconductor wafer underneath the pressure chamber 38 and the pressing force applied to a portion of the semiconductor wafer underneath the pressure chamber 40 can be independently adjusted. Therefore, a polishing rate (i.e., removal rate) can be adjusted at the peripheral portion of the semiconductor wafer and a portion located radially inwardly of the peripheral portion. In this manner, a polishing profile of the semiconductor wafer can be controlled.

As shown in FIG. 2, block-like projecting portions 42 are provided on the circumferential membrane 26 so as to project radially inwardly from a circumferential edge of the elastic membrane 20. In addition, as shown in FIGS. 2 and 3, engagement portions 44, which engage side surfaces of the projecting portions 42, are provided on a lower portion of the attachment member 22. It is preferable that each of the engagement portions 44 has a thickness larger than or equal to a thickness of the bottom-surface membrane 24. With this arrangement, when the elastic membrane 20 is about to be twisted due to rotation of the top ring 3, the projecting portions 42 of the elastic membrane 20 engage the engagement portions 44 of the attachment member 22 to thereby suppress twist of the elastic membrane 20 to a minimal level. Therefore, a polishing profile can be appropriately controlled, and high-quality polishing can be achieved.

Although six projecting portions 42 and six engagement portions 44 are alternately arranged at equal intervals in the example shown in FIG. 3, the number of projecting portions 42 and engagement portions 44 is not limited to this example. Additionally, a size of the projecting portions 42 and the engagement portions 44 is not limited to this example shown in FIGS. 2 and 3. Furthermore, the projecting portions 42 may be formed integrally with the circumferential membrane 26, or may be a different material attached to the circumferential membrane 26. It is preferable that the projecting portions 42 and the engagement portions 44 are arranged symmetrically about a center of the semiconductor wafer, i.e., a center of the retainer ring section 12, so as to receive equal forces.

As shown in FIG. 2, the circumferential membrane 26 has a bellows portion 46 positioned below the base portion 34 of the attachment member 22, and the circumferential membrane 28 has a bellows portion 48 positioned below the base portion 36 of the attachment member 22. These bellows portions 46 and 48 allow the circumferential membrane 26 and the circumferential membrane 28 to expand in a direction such that the elastic membrane 20 presses the semiconductor wafer against the polishing pad 1, i.e., in a pressing direction.

The above-mentioned block-like projecting portion 42 formed on the circumferential membrane 26 may cause obstruction to expansion and contraction of the circumferential membrane 26 of the elastic membrane 20 in the pressing direction. However, the bellows portions 46 and 48 formed in the circumferential membrane 26 and the circumferential membrane 28 can expand and contract to thereby compensate such obstruction of expansion and contraction of the circumferential membrane 26. Accordingly, a circumferential edge of the elastic membrane 20 can flexibly follow the polishing surface of the polishing pad 1.

In the above-mentioned embodiments, some portions, such as an outer circumferential portion and its nearby portion, of the attachment member 22, and/or an inner circumferential portion of the retainer ring section 12 may be made of low frictional material such as fluorine resin, because these portions are likely to come into sliding contact with the circumferential membrane 26 and 28. Further, in order to lower surface friction, the circumferential membranes 26 and 28 may be impregnated with silicon, fluorine, or their compounds. Such structures can prevent the elastic membrane 20 from being twisted during polishing, and can allow the circumferential membrane 26 and 28 to smoothly move with respect to the vertically movable member 14 and the retainer ring section 12. Accordingly, a polishing profile can be appropriately controlled, and hence high quality polishing can be achieved.

Although the polishing pad forms the polishing surface in the above embodiments, the present invention is not limited to such a structure. For example, the polishing surface may be constituted by a fixed abrasive. The fixed abrasive is a plate-like polishing tool comprising abrasive particles fixed by a binder. A polishing process using the fixed abrasive is performed by abrasive particles that are self-generated from the fixed abrasive. The fixed abrasive comprises abrasive particles, a binder, and pores. For example, cerium dioxide (CeO₂) having an average particle diameter of at most 0.5 µm is used as the abrasive particles, and epoxy resin is used as the binder. Such fixed abrasive forms a hard polishing surface. Examples of the fixed abrasive include, other than the above plate-like polishing tool, a fixed abrasive pad having a two-layer structure formed by a thin layer of a fixed abrasive and an elastic polishing pad attached to a lower surface of the thin layer of the fixed abrasive.

Although certain preferred embodiments of the present invention have been described, it should be understood that the present invention is not limited to the above embodiments, and various changes and modifications may be made within the scope of the present invention as defined ba by the claims.

### Industrial Applicability

The present invention is applicable to a substrate holding device for pressing a substrate via an elastic membrane against a polishing surface of a polishing apparatus.

## Claims

1. A substrate holding device (3) comprising:
an elastic membrane (20) to be brought into contact with a rear surface of a substrate (W);
an attachment member (22) for securing at least a portion of said elastic membrane (20); and
a retainer ring (12) for holding a peripheral portion of the substrate (W) while the
substrate (W) is in contact with said elastic membrane (20), wherein said elastic membrane (20) includes a circumferential membrane (26), **characterised in that** said elastic membrane (20) includes plural projecting portions (42) projecting radially inwardly of said circumferential membrane (26), and said attachment member (22) includes plural engagement portions (44) engaging side surfaces of said plural projecting portions (42).

2. The substrate holding device (3) according to claim 1, wherein said plural engagement portions (44) are arranged symmetrically about a center of the substrate (W).

3. The substrate holding device (3) according to claim 1, wherein said plural engagement portions (44) have a thickness larger than or equal to a thickness of said elastic membrane (20) to be brought into contact with the rear surface of the substrate (W).

4. The substrate holding device (3) according to claim 1, wherein said elastic membrane (20) comprises a bellows portion (46; 48) which is expandable in a pressing direction so as to allow said elastic membrane (20) to press the substrate (W), and is contractible along the pressing direction.

5. The substrate holding device (3) according to claim 4, wherein said elastic membrane (20) to be brought into contact with the substrate (W) is thicker than said bellows portion (46; 48).

6. The substrate holding device (3) according to any one of the preceding claims, wherein said attachment member (22) has an outer circumferential surface made of fluorine resin.

7. The substrate holding device (3) according to any one of the preceding claims, wherein said retainer ring (12) has an inner circumferential surface made of fluorine resin.

8. A polishing apparatus comprising:
a polishing table (2) having a polishing surface; and
a substrate holding device (3) according to any one of claims 1 to 7, wherein said substrate holding device (3) is operable to hold a substrate (W) and press the substrate (W) against said polishing surface to thereby polish the substrate (W).

## Patentansprüche

1. Substrathaltevorrichtung (3), die Folgendes aufweist.
eine elastische Membran (20), zum in Kontakt bringen mit einer Rückseite eines Substrats (W);
ein Anbringungsglied (22) zum Befestigen wenigstens eines Teils der elastischen Membran (20); und
einen Haltering (12) zum Halten eines Umfangsteils des Substrats (W) während das Substrat (W) in Kontakt mit der elastischen Membran (20) steht, wobei die elastische Membran (20) eine Umfangsmembran (26) aufweist, **dadurch gekennzeichnet, dass** die elastische Membran (20) eine Vielzahl von Vorsprungsteilen (42) aufweist, die radial nach innen bezüglich der Umfangsmembran (26) vorragen, und wobei das Anbringungsglied (22) eine Vielzahl von Eingriffsteilen (44) aufweist, welche mit den Seitenoberflächen der Vielzahl von Vorsprungsteilen (42) in Eingriff stehen.

2. Substrathaltevorrichtung (3) nach Anspruch 1, wobei die Vielzahl von Eingriffsteilen (44) symmetrisch um eine Mitte des Substrats (W) herum angeordnet sind.

3. Substrathaltevorrichtung (3) nach Anspruch 1, wobei die Vielzahl von Eingriffsteilen (44) eine größere oder gleiche Dicke besitzt wie die elastische Membran (20), zum in Kontakt bringen mit der Rückseite des Substrats (W).

4. Substrathaltevorrichtung (3) nach Anspruch 1, wobei die elastische Membran (20) einen Balgenteil (46; 48) aufweist, der in eine Druckrichtung ausfahr- bzw. dehnbar ist, um zu erlauben, dass die elastische Membran (20) das Substrat (W) drückt und die entlang der Drückrichtung zurückziehbar ist.

5. Substrathaltevorrichtung gemäß Anspruch 4, wobei die elastische Membran (20) zum in Kontakt bringen mit dem Substrat (W) dicker ist als der Balgenteil (46; 48).

6. Substrathaltevorrichtung (3) nach einem der vorgehenden Ansprüche, wobei das Anbringungsglied (22) eine äußere Umfangsoberfläche besitzt, die aus einem Fluorhartz besteht.

7. Substrathaltevorrichtung (3) nach einem der folgenden Ansprüche, wobei der Haltering (12) eine Innenumfangsoberfläche besitzt, die aus einem Fluorharz hergestellt ist.

8. Poliervorrichtung, die Folgendes aufweist:
einen Poliertisch (2) mit einer Polieroberfläche; und
eine Substrathaltevorrichtung (3) nach einem der Ansprüche 1 bis 7, wobei die Substrathaltevorrichtung (3) betriebsmäßig ein Substrat (W) hält und das Substrat (W) gegen die Polieroberfläche drückt, um das Substrat (W) dadurch zu polieren.

## Revendications

1. Dispositif (3) de maintien de substrat comprenant :
- une membrane élastique (20) devant être mise en contact avec la surface arrière d'un substrat (W) ;
- un élément de fixation (22) pour fixer au moins une partie de ladite membrane élastique (20) ; et,
- un anneau de maintien (12) permettant de tenir une partie périphérique du substrat (W) pendant que le substrat (W) est en contact avec ladite membrane élastique (20), laquelle membrane élastique (20) comprend une membrane circonférentielle (26)
**caractérisé en ce que** ladite membrane élastique (20) comprend plusieurs parties protubérantes (42) qui font saillie radialement vers l'intérieur de ladite membrane circonférentielle (26), et **en ce que** ledit élément de fixation (22) comprend plusieurs parties de contact (44) en engagement avec des surfaces latérales desdites plusieurs parties protubérantes (42).

2. Dispositif (3) de maintien de substrat selon la revendication 1, dans lequel lesdites plusieurs parties de contact (44) sont disposées symétriquement autour d'un centre du substrat (W).

3. Dispositif (3) de maintien de substrat selon la revendication 1, dans lequel lesdites plusieurs parties de contact (44) ont une épaisseur supérieure ou égale à l'épaisseur de ladite membrane élastique (20) devant venir en contact avec la surface arrière du substrat (W).

4. Dispositif (3) de maintien de substrat selon la revendication 1, dans lequel ladite membrane élastique (20) comprend une partie en soufflet (46 ; 48) qui est expansible dans une direction de pression de sorte que ladite membrane élastique (20) puisse presser le substrat (W), et qui peut être contractée dans la direction de pression.

5. Dispositif (3) de maintien de substrat selon la revendication 4, dans lequel ladite membrane élastique (20) devant venir en contact avec le substrat (W) est plus épaisse que ladite partie en soufflet (46 ; 48).

6. Dispositif (3) de maintien de substrat selon l'une quelconque des revendications précédentes, dans lequel l'élément de fixation (22) possède une surface circonférentielle externe faite d'une résine à base de fluor.

7. Dispositif (3) de maintien de substrat selon l'une quelconque des revendications précédentes, dans lequel l'anneau de maintien (12) possède une surface circonférentielle interne faite d'une résine à base de fluor.

8. Appareil de polissage comprenant :
- une table de polissage (2) possédant une surface de polissage ; et
- un dispositif (3) de maintien de substrat selon l'une quelconque des revendications 1 à 7, lequel dispositif (3) de maintien de substrat permet de maintenir un substrat (W) et de presser le substrat (W) contre ladite surface de polissage afin de polir ainsi le substrat (W).
